# EUROPÄISCHE PATENTSCHRIFT

(11) **EP 1 747 301 B1**
(45) Veröffentlichungstag und Bekanntmachung des Hinweises auf die Patenterteilung: **11.03.2009**
(21) Anmeldenummer: 04739338.4
(22) Anmeldetag: 25.05.2004
(51) Int. Cl.: C23C 14/56

(54) **BANDBEHANDLUNGSANLAGE**
STRIP PROCESSING SYSTEM
INSTALLATION DE TRAITEMENT DE BANDE

(43) Veröffentlichungstag der Anmeldung: 31.01.2007
(73) Patentinhaber: Applied Materials GmbH & Co. KG, 63755 Alzenau (DE)
(72) Erfinder: HEIN, Stefan, 63825 Blankenbach (DE)
(74) Vertreter: Bockhorni & Kollegen
(86) Internationale Anmeldenummer: PCT/EP2004/005618
(87) Internationale Veröffentlichungsnummer: WO 2005/116289

(56) Entgegenhaltungen:
- EP-A- 0 998 170
- WO-A-01/11106
- WO-A-99/50472
- DE-B- 1 078 402
- DE-C1- 10 157 186
- US-B1- 6 258 408
- PATENT ABSTRACTS OF JAPAN Bd. 2000, Nr. 14, 5. März 2001 (2001-03-05) & JP 2000 327186 A (SONY CORP), 28. November 2000 (2000-11-28)

## Beschreibung

Die Erfindung bezieht sich auf eine Bandbehandlungsanlage mit den Merkmalen des Oberbegriffs des Patentanspruchs 1.

Bandbehandlungsanlagen der hier in Rede stehenden Art dienen zum Behandeln, insbesondere zum Beschichten von flexiblen Bandsubstraten, z. B. Kunststofffolien, Magnetbändern, Filmen etc., im Vakuum (z. B. durch Sputtern, also Zerstäuben von Targets, das ggf. von Magnetfeldern unterstützt wird, Aufdampfen, PVD- oder CVD-Verfahren), aber auch zu weiteren Behandlungsformen wie Vorbehandlungen / Reinigen / Trocknen / Oberflächenaktivieren / Polymerisation etc. Hierbei ist es erforderlich, die in Ballen- oder Trommelform gewickelten Bandsubstrate oder Folien in die Anlage einzubringen und sie auf einer Lagerachse aufzunehmen, so dass das Bandsubstrat während des Behandlungsdurchlaufs von diesem Ballen abgewickelt werden kann.

Jenseits / stromab der Behandlungskammer(n) ist eine weitere Achse mit einer Aufwickeltrommel vorgesehen, auf welche das bearbeitete Bandsubstrat wieder aufgewickelt wird.

Eine solche Behandlungsanlage ist also grundsätzlich in Module unterteilbar (Abwickel-, Behandlungs- und Aufwickelmodul).

Bei bekannten Anlagen sind die beiden beidseitig gelagerten Achsen oder Walzen zum Abwickeln und Aufwickeln des Bandsubstrats auf einer gemeinsamen rahmenartigen Basis angebracht, was den Vorteil hat, dass sie in einer konstanten und festen Lagebeziehung zueinander stehen. Wenn die beiden Achsen oder Walzen allerdings beidseits des Behandlungsmoduls angeordnet sind, so ist es beiln Spulenwechsel praktisch nicht vermeidbar, auch die im Vakuum arbeitenden Behandlungs- oder Beschichtungskammern zu belüften.

Es ist anzustreben, im Vakuum arbeitende Beschichtungskammer nicht bei jedem Wechsel des Substratballens bzw. beim Entnehmen eines aus fertig beschichtetem Bandsubstrat neu gewickelten Ballens zu fluten / zu belüften.

Es ist deshalb schon bekannt, Schleusenventile zwischen den einzelnen Modulen vorzusehen. Damit wird das insgesamt wieder zu entlüftende Volumen deutlich verringert, da nur noch die Einlege- bzw. Entnahmestationen belüftet werden und die eigentliche Beschichtungslcammer stets im evakuierten Zustand verbleiben kann. Natürlich kann bei Bedarf die gesamte Anlage belüftet werden.

DE 197 35 603 C1 beschreibt eine Durchlauf-Vakuumbeschichtungsanlage mit mehreren hintereinander liegenden Beschichtungskammenrn, bei der innerhalb jeder Beschichtungskammer je ein Walzenstuhl angeordnet ist, welcher Umlenkrollen, Bandzugmesswalzen und Kühlwalzen trägt. Die Walzenstühle sind dabei in ihrer jeweiligen Beschichtungskammer so verstellbar, dass die Rollen und Walzen der aufeinander folgenden Kammern zueinander einjustierbar sind. Die Magnetron-Sputterquellen (Targets) dieser Beschichtungskammem sind unabhängig von den Walzenstühlen gelagert, so dass sie sowohl justiert als auch ausgetauscht werden können, ohne die Stellungen der Walzen zu verändern.

Das zu behandelnde Bandsubstrat wird aus einer Abwickelkammer in die Beschichtungskammern eingeführt und stromab der letzteren in eine Aufwickelkammer überführt, wobei jeweils zwischen den Abwickel- und Aufwickelkammern und den Beschichtungskammern Vakuumventile angeordnet sind, auf die nicht näher eingegangen wird.

DE 101 57 186 C1 beschreibt eine andere Durchlauf-Vakuumbeschichtungsanlage mit einer Aufteilung in Abwickel-, Beschichtungs- und Aufwickel-Kammern, zwischen denen Schleusen- oder Bandventile vorgesehen sind. Die in den evakuierbaren Abwickel- und Aufwickelkammem angeordneten Spulenachsen sind jeweils auf Walzenstühlen gelagert, die unabhängig voneinander befestigt und getrennt voneinander aus der Anlage ausfahrbar sind. Demgegenüber sind die Walzen im Behandlungsmodul auf einem gemeinsamen Walzenstuhl angeordnet. Für alle Walzenstühle sind gemeinsame Befestigungs- oder Auflagerpunkte an den Trennwänden zwischen den Wickelkammern und dem Behandlungsmodul vorgesehen. Gegenseitige Verschiebungen der Walzenstühle im Betrieb sollen dadurch ausgeschlossen werden, dass im Betrieb eine maximale Druckdifferenz von 50 Pa zwischen Wickelkammern und Behandlungsmodul zugelassen wird. Der Behandlungsmodul ist mit einem separaten Deckel verschließbar, der seinerseits mit Wartungstüren versehen ist.

WO 99/50 472 beschreibt eine Vakuum-Bandbehandlungsanlage, die eine Lade- bzw. Entladestation nebst zugehörigen Auf- und Abwickelhaspeln in einer gemeinsamen Kammer und mindestens eine davon getrennte Reaktionskammer (Behandlungsmodul) umfasst. Das Bandsubstrat durchläuft zwischen Lade- bzw. Entladestation und Reaktionskammer als Druckstufen dienende Walzenschleusen. Es kann dabei in einer Ausführung zwischen zwei aufeinander abrollenden Walzen, in einer anderen Ausführung zwischen einer Walze und einem feststehenden Abdichtungsblock durchlaufen. Diese Walzenschleusen können geöffnet werden, um z. B. ein neues Bandsubstrat einzufädeln. Zu diesem Zweck ist entweder eine der Walzen wegklappbar, indem ihre Rotationsachse um eine Schwenkachse klappbar gelagert ist, oder der Abdichtungsblock wird von der Walze abgezogen.

In einer Ausführungsform dieser bekannten Anlage sind sämtliche Walzen und Ventile nebst Antriebe auf einer gemeinsamen Basis angeordnet, die in ein Gehäuse eingefahren werden kann. Die Fugen zwischen der Basis und dem Gehäuse sind mithilfe umlaufender Dichtungen vakuumdicht verschließbar. Allerdings können diese Dichtungen infolge ihres räumlichen Verlaufs insbesondere im Bereich der besagten Schleusenventile nicht sämtlich gegen ebene Dichtflächen angelegt werden. Auch bei dieser Anlage können die Bandspulen dank der Schleusenventile ausgetauscht werden, ohne die Behandlungskammer zu belüften.

Der Erfindung liegt die Aufgabe zu Grunde, eine weitere Bandbehandlungsanlage zu schaffen, mit der ein Wechsel der Abwickel- und Aufwickelspulen möglich ist, ohne die gesamte Anlage bzw. deren evakuierten Behandlungstrakt zu belüften.

Diese Aufgabe wird erfindungsgemäß mit den Merkmalen des Patentanspruchs 1 gelöst. Die Merkmale der Unteransprüche geben vorteilhafte Weiterbildungen der Erfindung an.

Erfindungsgemäß werden die Wickelstationen und die Behandlungsstation in oder auf unterschiedlichen, relativ zueinander bewegbaren Basen angeordnet. Die Basis der Behandlungsstation ist ein fester Teil des Anlagengehäuses, das im Betriebszustand auch die Wickelstationen umgibt.

Letztere sind in einem ihre gemeinsame Basis umfassenden und zum Behandlungsmodul hin offenen, gegenüber dem Anlagengehäuse beweglichen Gestell angeordnet und durch Ventile gegenüber der eigentlichen Behandlungsstation (oder dem Behandlungsmodul) abdichtbar.

Vorzugsweise ist die gemeinsame Basis eine geschlossene Platte, welche eine Wand des Gestells bildet. In einer besonders zweckmäßige Ausführung bildet diese Basisplatte der Wickelstationen im Betriebszustand zugleich eine Wand des Gehäuses der Gesamtanlage. Ferner bildet sie eine Wand einer in dem Gestell selbst ausgebildeten, im Wesentlichen geschlossenen Kammer.

Von außen sind ferner die Wickelstationen über gesonderte, im Betrieb dicht verschließbare Öffnungen des Anlagengehäuses zugänglich. Diesen Öffnungen entsprechen Öffnungen in der Kammer des die Wickelstationen tragenden Gestells. Nach dem Schließen der besagten Ventile und dem Belüften der Wickelstationen ist dadurch ein rascher Austausch der Bandspulen möglich, ohne die Gesamtanlage zu belüften und ohne die Wickelstationen aus dem Anlagengehäuse auszufahren.

Mit besonderem Vorzug umfasst das Gestell oder auch das Gehäuse der Anlage eine Dichtung, welche die Belade- und/oder Entladeöffnung umgibt. Diese Dichtung ist vorteilhaft durch Fluiddruck steuerbar, so dass sie eine Dichtstellung und eine Ruhestellung hat. In letzterer ist das einfache Aus- und Einfahren der Wickelstationen ohne Belastung der besagten Dichtung möglich. In der Dichtstellung kann die jeweilige Öffnung zum Ladungswechsel genutzt werden, ohne die Gesamtanlage zu belüften. Vorteilhaft kann diese Dichtung gegen eine ebene Innenwand des Gehäuses angelegt oder an dieser selbst angeordnet werden, um dann bei Bedarf gegen einen Flansch des Gestells angelegt zu werden.

Die Schleusenventile werden vorteilhaft mit einer Öffnung zum Durchführen des Bandsubstrats und einem Körper zum Verschließen dieser Öffnung ausgeführt, wobei die Schließstellung des Körper auch zum Festhalten des Bandsubstrats beim Wechsel von Substratspulen oder -trägern genutzt werden kann.

Weitere Einzelheiten und Vorteile des Gegenstands der Erfindung gehen aus der Zeichnung eines Ausführungsbeispiels und deren sich im Folgenden anschließender eingehender Beschreibung hervor.

Es zeigen in vereinfachter Darstellung
- Fig. 1: eine schematische Prinzipskizze in Schnittansicht der gesamten Durchlaufbehandlungsanlage gemäß der Erfindung;
- Fig. 2: eine gegenüber Fig. 1 um 90° geklappte Ansicht derselben Durchlaufbehandlungsanlage mit einem Gestell für die Wickelstationen in einer aus dem Gehäuse ausgefahrenen Stellung;
- Fig. 3: eine weitere Ansicht analog zu Fig. 2 der erfindungsgemäßen Durchlaufbehandlungsanlage mit dem in seine Arbeitsstellung in das Gehäuse eingefahrenen Gestell;
- Fig. 4: eine Seitenansicht einer Wickelstation und des Gestells und Gehäuses nebst einem Schleusenventil;
- Fig. 5: eine Variante zu Fig. 3, in der zwei Wickelstationen zum Auf- und Abwickeln in Tandemanordnung angeordnet sind und zwei Schleusenventile zu einer Baueinheit zusammen gefasst sind;
- Fig. 6: eine bevorzugte Ausführungsform eines Schleusenventils.

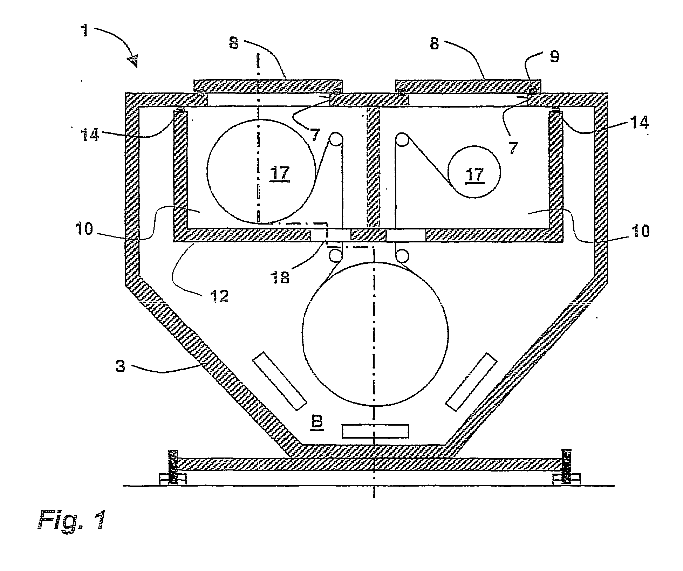

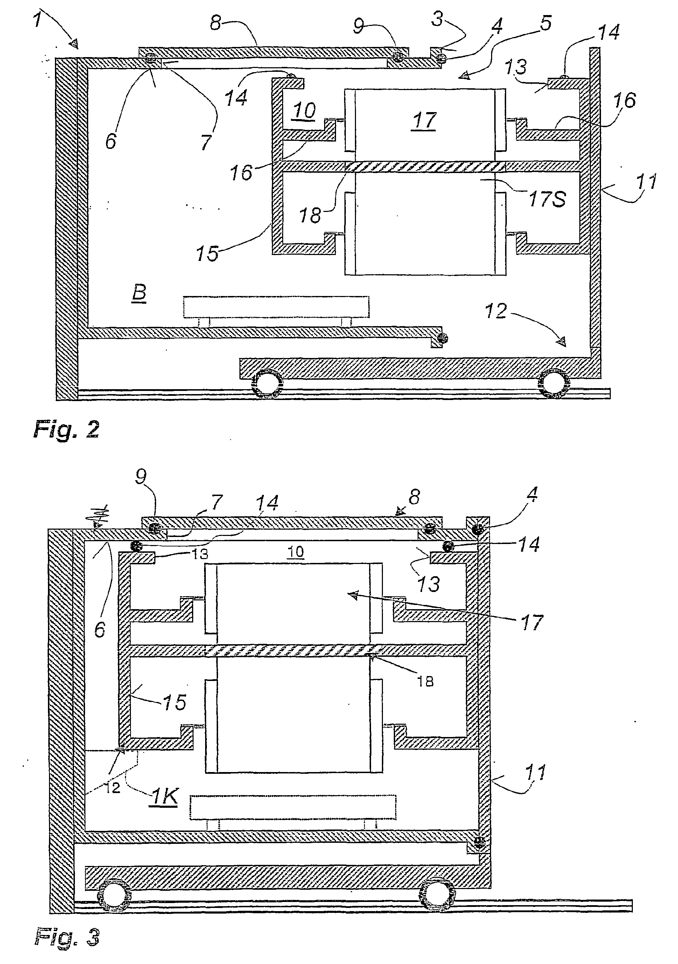

In **Fig. 1** erkennt man ein Gehäuse 1 einer Durchlaufbehandlungsanlage, das insgesamt mit nicht näher gezeigten Mitteln evakuierbar ist. Es hat an einer Seite eine große, von einem Flansch 3 umgebene Öffnung (in dieser Ansicht schaut man durch diese Öffnung hinein). **Fig. 2** und **3** verdeutlichen den Zweck dieser Haupt-Öffnung 5; sie ermöglicht das Ein- und Ausfahren eines Gestells 12 für Wickelstationen 10, und damit des gesamten Vorrats an Bandmaterial, das in einem Arbeitsgang in der Anlage behandelt werden soll. Auf dem Flansch 3 ist eine umlaufende Dichtung 4 angeordnet.

Am Boden des Gehäuses 1 ist eine Behandlungseinrichtung B nur angedeutet, die z. B. mindestens eine Sputterkathode umfassen kann. Alle Umlenk- und Kühlwalzen gehören zum Wickelsystem und sind an dem Gestell 12 gelagert. Während Fig. 1 noch die Anordnung einiger Umlenkwalzen gelingen Durchmessers zeigt, sind diese in Fig. 2 und 3 der Übersichtlichkeit halber weggelassen. Dort sind nur noch zwei Walzen gezeigt, nämlich eine (obere) Auf- oder Abwickelwalze 17 und die darunter liegende Kühl- oder Beschichtungswalze.

Das Gestell 12 ist in **Fig. 2** in seiner ausgefahrenen Stellung gezeigt, in der die gesamte Anlage bzw. das gesamte Gehäuse 1 belüftet ist.

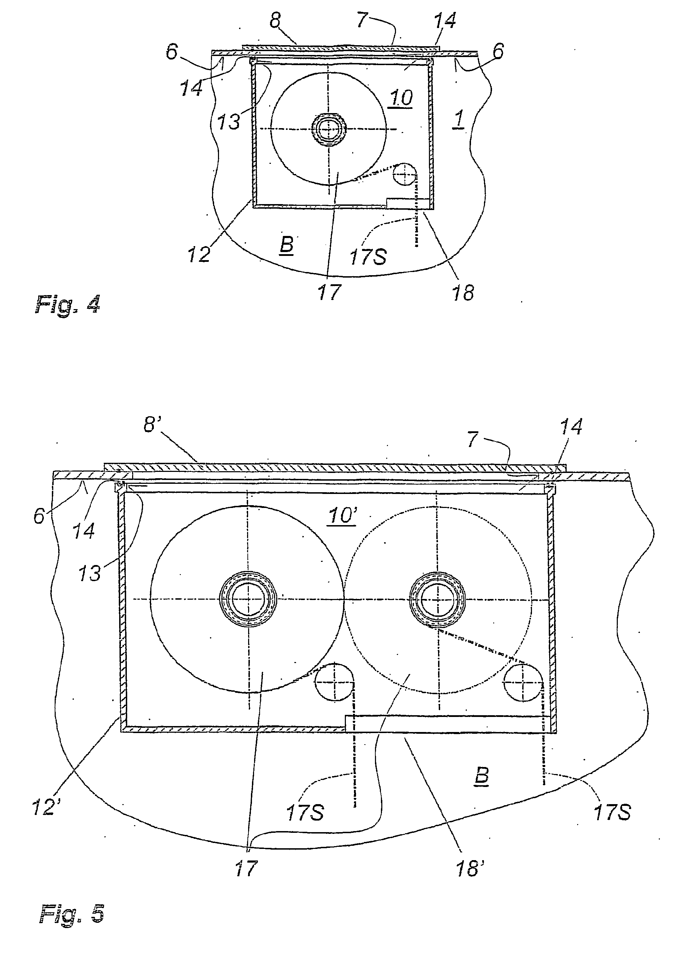

**Fig. 3** zeigt demgegenüber die in das Gehäuse 1 eingefahrene (Arbeits- oder Betriebs) Stellung des Gestells 12. Im Weiteren wird zunächst nur eine Wickelstation beschrieben; die zweite Wickelstation ist funktionsgleich mit der hier beschriebenen ausgeführt. Diese liegt in Fig. 2 und 3 verdeckt in Blickrichtung hinter der Wickelstation / Walze 17, in Fig. 1 und 5 sind beide zu sehen.

Der Verlauf des Schnitts der Fig. 2 und 3 ist in Fig. 1 durch eine strichpunktierte, mehrfach abknickende Linie angedeutet. Die Trennwand zwischen den beiden Wickelstationen 17 in Fig. 1 ist nicht funktionsnotwendig und kann ggf. weggelassen werden, wenn man nicht beabsichtigt, die beiden Wickelstationen unabhängig voneinander zu belüften. Die Fig. 1 zeigt einen Schnitt sowohl durch das Gehäuse 1 als auch durch das darin befindliche Gestell 12 nebst den darin aufgenommenen Walzen.

Das zu beschichtende Bandsubstrat wird von einer Abwickelwalze 17 zur darunter liegenden Beschichtungswalze und durch die Behandlungsstation B geführt. Letztere kann natürlich auch mehrere Sputterkathoden umfassen. Danach wird es wieder nach oben geführt und von der Aufwickelwalze aufgenommen (wie es in Fig. 1 insgesamt erkennbar ist).

In der oberen Innenwand 6 (oberhalb der Wickelstation 10) des Gehäuses 1 ist mindestens eine Öffnung 7 vorgesehen, die normalerweise mittels eines Kammerdeckels 8 verschlossen ist. Dieser liegt auf dem die Öffnung 7 umgebenden Rand der Innenwand 6 und ist mithilfe einer umlaufenden Dichtung 9 zuverlässig abgedichtet. Wie man in Fig. 1 erkennt, ist für jede Wickelstation eine eigene Öffnung 7 nebst Kammerdeckel 8 und Dichtung 9 vorgesehen.

In derselben ebenen Innenwand 6 tritt auch die innere (kammerseitige) Öffnung eines hier nicht gezeigten Pumpstutzens aus.

Den Kammerdeckel 8 kann man vorteilhaft bei eingefahrenen Wickelstationen öffnen.

Das Gestell 12 trägt eine zur Wickelstation 10 gehörende geschlossen plattenförmige Basis 11. Es umfasst ferner eine obere Öffnung 13 und eine diese umgebende umlaufende und vorzugsweise durch Fluiddruck aufblähbare "aktive" Dichtung 14, eine geschlossene (Wider-)Lagerplatte 15, zwei Aufnahmen 16 für Substratspulen oder -ballen, die jeweils an der Basis 11 und an der Lagerplatte 15 fest angeordnet sind, und schließlich eine auf den Aufnahmen 16 drehbar aufgelegte Substratspule 17. Die darunter liegende Beschichtungswalze ist auf eigenen Lager-Aufnahmen unabhängig von der Abwickelwalze gelagert.

Die Dichtung 14 ist auf einem die Öffnung 13 umgebenden Flansch angeordnet; die für ihren Betrieb benötigten Fluiddruck-Anschlüsse sind hier vereinfachend nicht dargestellt.

Die Dichtung wird man vorzugsweise in einer umlaufenden Nut des Flansches anordnen, damit sie im nicht aktiven Zustand gut vor mechanischer Beschädigung geschützt ist.

Die Basis 11 und die Lagerplatte 15 bilden jeweils eine geschlossene Seitenwand des Gestells 12. Der obere Teil des Gestells 12 bildet insgesamt eine die Substratspule 17 umgebende, im Wesentlichen geschlossene Kammer, die nur über die Öffnung 13 zugänglich ist.

**Fig. 3** verdeutlicht die Funktion der Dichtung 14, die hier nach dem Einfahren des Gestells 12 in das Gehäuse 1 aufgebläht wurde und sich rings um die Öffnung 13 an die Innenwand 6 des Gehäuses angelegt hat. Man erkennt ferner, dass der Rand der plattenförmigen Basis 11 in der End- oder Arbeitsstellung der Wickelstation 10 umlaufend auf dem Flansch 3 der Öffnung 5 des Gehäuses 1 aufliegt und diese verschließt, wobei ihre Innenfläche gegen die Dichtung 4 anliegt. Somit ist die Öffnung 5 dicht verschlossen, und die Basis 11 bildet in dieser Stellung eine Wand des Gehäuses 1.

Unterhalb der Widerlagerplatte 15 ist in Fig. 3 eine Konsole 1K angedeutet, auf der das Gestell 12 bzw. dessen Kammer bei Bedarf innerhalb des Gehäuses 1 abstützbar ist. Abweichend von dieser stark vereinfachten Darstellung kann man eine solche Abstützung auch als Führungsschiene oder dgl. im Gehäuse 1 mit entsprechenden Gegenstücken am Gestell 12 ausführen, auf der die Widerlagerplatte 15 und damit die Gesamtheit der Walzen nicht nur im eingefahrenen Zustand, sondern auch während jedes Aus- und Einfahrvorgangs abgestützt wird.

Die Öffnung 13 im Gestell 12 der Wickelstation 10 ist hinreichend groß und so positioniert, dass sie die Öffnung 7 der Innenwand 6 mit dem Kammerdeckel 8 überdeckt. Die aufblähbare Dichtung 14 umgibt folglich ebenfalls die Öffnung 7.

Die Dichtung 14 könnte abweichend von der Darstellung grundsätzlich auch an der Innenwand 6 des Gehäuses 1 an gleicher Stelle angeordnet werden, um sich im aufgeblähten Zustand an den die Öffnung 13 des Gestells 12 umgebenden Flansch anzulegen.

Vor Inbetriebnahme der Behandlungsanlage und nach dem lagerichtigen Fixieren des Gestells 12 im Gehäuse 1 wird das Gehäuse 1 durch Absaugen der Luft mittels der nicht dargestellten Pumpeinrichtung evakuiert. Dabei kann die Dichtung 14 an die ebene Innenwand 6 des Gehäuses 1 angelegt werden (Dichtstellung), indem man ihr über die erwähnten, nicht gezeigten Fluidanschlüsse Druck zuführt.

Sie muss allerdings nicht unbedingt während des normalen Betriebs der Behandlungsanlage ständig "aktiviert" werden oder bleiben, da das Gehäuse 1 sowohl die Wickelstationen als auch die Behandlungsstation umschließt, die somit gleichzeitig evakuiert werden. Die Dichtung 14 wird nur dann wirklich benötigt, wenn man die Wickelstation 10 unabhängig vom restlichen Gehäuse 1 belüften, d. h. den / die Kammerdeckel 8 öffnen will.

Während der Bewegungsphasen der Wickelstation 10 relativ zum Gehäuse 1 -also außerhalb des Betriebszustandes der Anlage, z. B. bei Wartungs- oder Reinigungsarbeiten, die nicht einfach nach dem Öffnen eines Kammerdeckels 8 ausführbar sind- oder bei vollständig (einschließlich der Wickelkammer 10) evakuierte Gehäuse 1 wird man die Dichtung 14 entspannen (ihren Innendruck abbauen) oder sie mit einem geringen Unterdruck beaufschlagen. Dadurch zieht sie sich weitgehend in ihre Sitznut zurück (Rückzugstellung), in der sie vor Reibung und Beschädigung geschützt ist.

Wie durch Vergleich der Fig. 2 und 3 erkennbar, verlaufen Bewegungen des Gestells 12 relativ zum Gehäuse 1 parallel zu der Achse der Wickelstation 10 bzw. der Substratspule 17.

Unterhalb der Substratspule 17 ist ein Bandsubstrat 17S aus der Wickelstation 10 im Gestell 12 nach unten in den Behandlungsmodul B geführt. Die entsprechende Öffnung der Wickelkammer bzw. der Wickelstation 10 ist gegenüber dem Gehäuse 1 und der Behandlungsstation B durch ein Schleusenventil 18 abschließbar. Letzteres befindet sich in dem beweglichen Gestell 12; es wird also beim Öffnen bzw. Ausfahren des Gestells 12 aus dem Gehäuse 1 mitgenommen.

Das Schleusenventil 18 ermöglicht es, die in den Wickelstationen 10 befindlichen Substratträger oder -spulen 17 auszutauschen, ohne das Gehäuse 1 insgesamt zu belüften. Wie später noch näher beschrieben wird, schließt das Schleusenventil 18 in seiner Schließstellung die Behandlungsstation B gegenüber der Wickelstation 10 spaltfrei ab. Es ist als statisches Ventil ausgelegt, das im Betrieb der Anlage einen verhältnismäßig großen freien Querschnitt hat, den das Bandsubstrat berührungsfrei durchlaufen kann.

In **Fig. 4** erkennt man in gesonderter Darstellung eine geklappte Ansicht einer Wickelstation 10. Diese verdeutlicht weiter, dass die vom Kammerdeckel 8 verschlossene Öffnung 7 des Gehäuses 1 hinreichend groß ist, um die Substratspule 17 nach dem Öffnen des Kammerdeckels 8 ohne Verschieben der Wickelstation 10 gegenüber dem Gehäuse 1 auszutauschen, d. h. auszuheben und eine neue Substratspule einzulegen.

Man erkennt in dieser Ansicht wieder gut, wie das von der Substratspule 17 abziehbare flexible Substrat 17S aus dem Gestell 12 in den hier unterhalb der Wickelstation befindlichen Behandlungsmodul B über (wenigstens) eine Umlenkrolle und durch das auch hier nur schematisch angedeutete Schleusenventil 18 überführt wird. Letzteres ist fest in das Gestell 12 eingebaut.

Das Gestell 12 der Wickelstationen 10 bildet somit, wie schon erwähnt, eine Kammer, die durch die gemeinsame Basis 11 und die Lagerplatte 15 (Fig. 4 und 5), durch eine weitere, mit einer das Schleusenventil 18 aufnehmenden Öffnung versehene Boden-Wand sowie durch die hier rechts und links der Substratspule 17 sichtbaren Seitenwände umschlossen ist.

Gleichwohl ist diese Kammer durch die vom Kammerdeckel 8 verschlossene und von der Dichtung 14 ringsum abgedichtete Öffnung 7 von außen auch dann zugänglich, wenn sie sich im Betriebszustand innerhalb des Gehäuses 1 der Behandlungsanlage befindet.

Auch der Wickelstation 10 gemäß Fig. 4 steht jenseits (stromab) des Behandlungsmoduls B eine weitere, hier nicht gezeigte Wickelstation gleichen Typs gegenüber, die man sich spiegelbildlich zur Wickelstation 10 ausgeführt vorstellen kann, einschließlich der Möglichkeit, die darin aufgenommene Substratspule über eine Öffnung aus dem Gehäuse 1 zu entnehmen bzw. zu ersetzen.

Man kann vorsehen, dass die Wickelstationen 10 unabhängig voneinander geöffnet und belüftet werden können, d. h. während die eine belüftet ist, kann die andere immer noch evakuiert bleiben (dann ist die in Fig. 1 gezeigte Trennwand natürlich fünktionsnotwendig), oder dass grundsätzliche beide Wickelstationen gemeinsam belüftet werden. Im letzteren Fall müssen sie gegeneinander nicht gesondert abgedichtet werden.

Diese zweite Wickelstation 10 ist entsprechend dem in Fig. 1 gezeigten Prinzip in demselben Gestell 12 aufgenommen und somit lagestabil gegenüber der Wickelstation 10. Beide sind folglich mittels des Gestells 12 gemeinsam -nach dem Öffnen der Dichtung 14- aus dem Gehäuse 1 ausfahrbar.

Besagtes Schleusenventil 18 ist imstande, im Schließzustand erhebliche Druckdifferenzen, z. B. zwischen Atmosphärendruck und Vakuum, zuverlässig gegeneinander abzuschließen.

Es kann aber auch geöffnet werden, einerseits um ungehinderte Durchströmung und Durchlauf des Substrats zu ermöglichen, andererseits um das Durchziehen bzw. Einfädeln neuer Substrate zu ermöglichen, wenn das zuvor behandelte flexible Substrat vollständig aus der Anlage entfernt wurde. Selbstverständlich wird die Öffnungsweite des Ventils passend zu den Abmessungen (insbesondere Breite) der zu behandehlden Substrate dimensionieit.

Schließlich können aber auch mithilfe des Schleusenventils 18 Endstücke des fertig behandelten Bandsubstrats festgehalten werden, um neue Bandsubstrate in an sich bekannter Weise an diese anzuheften und anschließend anstelle aufwändigen manuellen Einfädelns das neue Bandsubstrat mithilfe des "alten" Reststücks ein- und durchzuziehen.

Es wäre also grundsätzlich möglich, diese Schleusenventile so auszuführen wie in der weiter oben erörterten WO-A1 99/50472. Jedoch sind auch andere Ausführungsformen verwendbar. Ein Ausführungsbeispiel wird später anhand von Fig. 5 schematisch erörtert.

Die Schleusenventile 18 sind damit sehr wesentlich für die vorstehend beschriebene Option zum Austausch der Substratspulen ohne vollständiges Ausfahren der Wickelstation(en) 10. Denn sie ermöglichen im Schließzustand das Öffnen des Kammerdeckels 8, ohne dass dabei der evakuiert Behandlungsmodul B ebenfalls belüftet wird.

In **Fig. 5** ist noch eine Ausführungsvariante der erfindungsgemäßen Behandlungsanlage dargestellt, die zwei Wickelstationen in einem kompakten gemeinsamen Gestell 12' zu einem Wickelmodul 10' in Tandemanordnung zusammenfasst. Dies hat den Vorteil, dass beide Substratspulen 17 durch einen einheitlichen Kammerdeckel 8' zugänglich sein können, so dass auch im Gehäuse 1 nur eine einzige Öffnung vorzusehen und abzudichten ist. Auch die umlaufende Dichtung 14 kann in dieser Bauform für beide Wickelstationen einheitlich und evtl. einfacher ausgeführt werden.

Ferner können die beiden Schleusenventile 18 hier zu einer Baueinheit 18' zusammengefasst werden, wenngleich natürlich für jedes auslaufende bzw. einlaufende Substrat-Trum eine eigene / unabhängige Ventilfunktion vorzusehen sein wird.

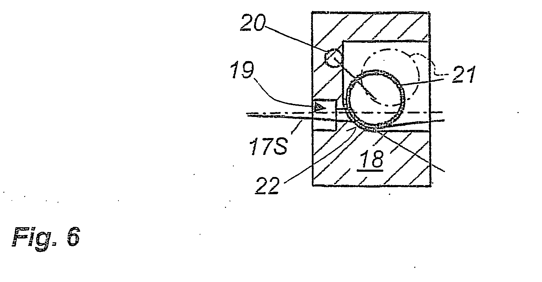

**Fig. 6** schließlich zeigt einen Querschnitt durch eine Ausführungsform eines Schleusenventils 18, das im Rahmen der hier beschriebenen Durchlaufbehandlungsanlage bevorzugt verwendbar ist. Man erkennt das Substrat 17S, das das Schleusenventil 18 und im engeren Sinne eine von diesem verschließbare (schlitzförmige) Öffnung 19 durchläuft. Zum Ventil 18 gehört ein in dessen Gehäuse oder Gestell um eine Achse 20 zwischen der gezeigten Schließstellung und einer nur strichpunktiert angedeuteten Öffnungsstellung schwenkbar gelagerter, hier walzenförmiger Ventilkörper 21. Zwar könnte dieser Walzenkörper 21 auf dem Substrat 17S abrollen, es ist jedoch vorgesehen, dass im Durchlaufbetrieb der Behandlungsanlage der Ventilkörper 21 das Substrat 17S nicht berührt. Zur Verdeutlichung ist auch der ungefähre Verlauf des Substrats 17S bei geöffnetem Ventil 18 strichpunktiert angedeutet. Jedenfalls beim ablaufenden, fertig behandelten / beschichteten Substrat-Trum sollte Reibungslcontakt mit Anlagenbauteilen nach Möglichkeit vermieden werden (bei bekannten Anlagen werden die Ventile deshalb mitunter mit minimalen Luftspalten ausgeführt).

Die zum Ventilkörper 21 gerichtete Fläche innerhalb des Gehäuses, in welche die Öffnung 19 austritt, ist erkennbar so gestaltet, dass das Substrat 17S zwischen dem Rand der besagten Öffnung (der zugleich als Dichtfläche 22 dient bzw. ausgestaltet sein kann) und dem in Schließstellung überführten Ventilkörper 21 im Stillstand eingespannt werden kann, ohne dabei übermäßig abgeknickt zu werden. Die Fläche 22, die zur Dichtkante hin verläuft, ist schräg zur Ebene des Bandsubstrats angestellt. Auch ist die vom Ventilkörper 21 ggf. mit dazwischen liegendem Substrat 17S verschließbare Dichtfläche 22 an der Öffnung 19 so ausgelegt (ggf. unter Verwendung weichelastischer Werkstoffe als Kanten- oder Flächendichtungen), dass eine gute Dichtwirkung unabhängig davon gewährleistet bleibt, ob der Ventilkörper 21 allein oder zusammen mit dem Substrat aufgedrückt wird.

Vorzugsweise wird man das Schleusenventil 18 in dem Gestell 12 oder 12' als separaten Modul ausführen. Dies gilt insbesondere auch für die in Fig. 4 gezeigte Zusammenfassung zweier an sich unabhängig voneinander schaltbarer Schleusenventile zu einem Ventilblock.

Diese Gestaltung ermöglicht es, wie schon weiter oben ausgeführt, einerseits bei noch in der Anlage befindlichem Restsubstrat die Wickelstationen 10 oder 10' zu belüften, während der Behandlungsmodul B evakuiert bleibt, andererseits nach dem Austausch der Substratspulen das neue Bandsubstrat mithilfe des verbliebenen, in den Ventilen eingespannten Reststückes einzuziehen. Man wird dazu den Anfang des neuen Bandsubstrats mit dem Reststück verkleben.

## Patentansprüche

1. Durchlaufbehandlungsanlage zum Bearbeiten, insbesondere zum Beschichten von durchlaufenden flexiblen Substraten (17S) wie Bändern, Folien und dgl., umfassend je eine Wickelstation (10; 10') zum Ab- und zum Aufwickeln des flexiblen Substrats, mindestens eine im Durchlauf des Substrats zwischen diesen beiden Stationen angeordnete Behandlungsstation (B), und jeweils zwischen einer Wickelstation (10; 10') und der mindestens einen Behandlungsstation angeordnete Ventile (18) zum Erhalten unterschiedlicher Druckniveaus in den Wickelstationen und der mindestens einen Behandlungsstation, wobei die Wickelstationen auf einer beweglichen Basis (11) angeordnet und z. B. zum Wechsel des Substrats aus der Anlage ausfahrbar sind, **dadurch gekennzeichnet, dass**
- die Wickelstationen (10; 10') und die Behandlungsstation (B) in oder auf unterschiedlichen, relativ zueinander bewegbaren Basen angeordnet sind, wobei die Basis der Behandlungsstation fest und als Teil eines die Behandlungsstation (B) und im Betriebszustand auch die Wickelstationen (10; 10') umschließenden und die Ventile (18) enthaltenden Gehäuses (1) ausgeführt ist,
- die Wickelstationen (10; 10') in einem ihre Basis (11) umfassenden und von den Ventilen (18) verschließbare Öffnungen aufweisenden Gestell (12) angeordnet sind, das im Betriebszustand innerhalb des Gehäuses (1) der Behandlungsstation aufgenommen ist, wobei im geöffneten Zustand der Ventile (18) die Behandlungsstation (B) und die Wickelstationen (10; 10') gemeinsam evakuierbar und im geschlossenen Zustand der Ventile (18) die Behandlungsstation (B) in einer abdichtenden Weise gegenüber den Wickelstationen (10; 10') verschlossen ist, so dass die Wickelstationen unabhängig von der Behandlungsstation belüftbar sind.

2. Durchlaufbehandlungsanlage nach Anspruch 1, **dadurch gekennzeichnet, dass** die Basis (11) der Wickelstationen eine Wand des Gestells (12) bildet und mindestens ein Auflager (16) für einen Substratträger (17) umfasst.

3. Durchlaufbehandlungsanlage nach Anspruch 1 oder 2, **dadurch gekennzeichnet, dass** die Basis (11) der Wiclcelstationen im Betriebszustand der Anlage wenigstens einen Abschnitt einer Wand des Gehäuses (1) bildet.

4. Durchlaufbehandlungsanlage nach Anspruch 1 oder 2 oder 3, **dadurch gekennzeichnet, dass** das Gestell (12) der Wickelstationen eine durch die gemeinsame Basis (11) und eine Lagerplatte (15) sowie durch eine weitere, mit einer zu einem Schleusenventil (18) gerichteten Öffnung versehene Wand und Seitenwände umschlossene Kammer bildet.

5. Durchlaufbehandlungsanlage nach einem der vorstehenden Ansprüche, **dadurch gekennzeichnet, dass** ihr Gehäuse (1) mindestens eine mittels eines Kammerdeckels (8) verschließbare Belade- und/oder Entladeöffnung (7) für eine Wickelstation aufweist.

6. Durchlaufbehandlungsanlage nach Anspruch 4 und 5, **dadurch gekennzeichnet, dass** eine Öffnung (13) der Kammer des Gestells (12) bei in dem Gehäuse (1) befindlichem Gestell (12) zu der vom Kammerdeckel (8) verschlossenen Öffnung (7) gewandt und auf diese ausgerichtet ist, um einen Wechsel der Substratträger (17) nach Öffnen des Kammerdeckels (8) zu ermöglichen.

7. Durchlaufbehandlungsanlage nach Anspruch 6, **dadurch gekennzeichnet, dass** die Öffnung (13) von einer Dichtung (14) umgeben ist, welche im Betriebszustand der Anlage zwischen einer Innenwand (6) des Gehäuses (1) und dem Rand der Öffnung (13) anlegbar ist, wobei diese Dichtung (14) in dem Gestell (12) oder in dem Gehäuse (1) angeordnet ist.

8. Durchlaufbehandlungsanlage nach Anspruch 7, **dadurch gekennzeichnet, dass** die Dichtung (14) gegen eine ebene Innenwand (6) des Gehäuses anlegbar ist.

9. Durchlaufbehandlungsanlage nach Anspruch 7 oder 8, **dadurch gekennzeichnet, dass** die Dichtung (14) durch Fluiddruck steuerbar ist, vorzugsweise in eine Dichtstellung (druckbeaufschlagt) und eine Rückzugstellung (entspannt oder mit Unterdruck beaufschlagt).

10. Durchlaufbehandlungsanlage nach Anspruch 7 oder 8, **dadurch gekennzeichnet, dass** ein Anschluss zum Evakuieren der Anlage in die von der Dichtung (14) umschlossene Fläche ausmündet.

11. Durchlaufbehandlungsanlage nach einem der vorstehenden Ansprüche, **dadurch gekennzeichnet, dass** mindestens ein Schleusenventil (18) in dem Gestell (12) der Wickelstationen (10) angeordnet ist.

12. Durchlaufbehandlungsanlage nach Anspruch 11, **dadurch gekennzeichnet, dass** das Schleusenventil (18) eine Dichtfläche (5) umfasst, die eine zum Durchführen des Substrats (17) vorgesehene Öffnung (19) rahmenartig umgibt, und einen Körper (21) zum Schließen der Öffnung (19), der so auf die Dichtfläche und/oder auf das sich durch die Öffnung (19) erstreckende Substrat (17) pressbar ist, dass er die Öffnung (19) durch wenigstens mittelbares Anlegen an die Kanten der Dichtfläche verschließt.

13. Durchlaufbehandlungsanlage nach Anspruch 12, **dadurch gekennzeichnet, dass** das Bandsubstrat mittels des Körpers (21) in der Öffnung (19) fixierbar ist, insbesondere um das Einziehen eines neuen Substrats mithilfe eines in dem Schleusenventil (18) fixierten Reststücks zu unterstützen.

14. Durchlaufbehandlungsanlage nach einem der vorstehenden Ansprüche, **dadurch gekennzeichnet, dass** die Ventile (18) jeweils einzeln oder in einer Mehrzahl in einem separaten Gehäuse oder Gestell angeordnet und in dem Gestell (12) befestigt sind.

## Claims

1. Through-feed treatment plant for processing, and in particular coating, continuous flexible substrates (17S) such as tapes, films and the like, comprising winding stations (10; 10') for respectively unwinding and rewinding the flexible substrate, at least one treatment station (B) arranged in the feed path of the substrate between these two stations, and valves (18) arranged between the respective winding stations (10; 10') and the at least one treatment station to maintain different pressure levels in the winding stations and the at least one treatment station, wherein the winding stations are arranged on a movable stand (11) and are traversable out of the plant e.g. for substrate changes, **characterized in that**
• the winding stations (10; 10') and the treatment station (B) are arranged in or on different stands that are movable relative to each other, the treatment-station stand being fixed and constructed as part of a housing (1) that encloses the treatment station (B) and in the operative condition the winding stations (10; 10') too, and also contains the valves (18),
• the winding stations (10; 10') are arranged on a chassis (12) which includes their stand (11) and has openings closable by the valves (18), and in the operative condition is accommodated within the housing (1) of the treatment station, the treatment station (B) and the winding stations (10; 10') being jointly evacuatable when the valves (18) are open and the treatment station (B) being sealed off from the winding stations (10; 10') when the valves (18) are closed so that the winding station can be vented independently of the treatment station.

2. Through-feed treatment plant according to Claim 1, **characterized in that** the stand (11) of the winding stations forms one wall of the chassis (12) and comprises at least one support (16) for a substrate carrier (17).

3. Through-feed treatment plant according to Claim 1 or Claim 2, **characterized in that** in the operative condition of the plant, the stand (11) of the winding stations forms at least a section of one wall of the housing (1).

4. Through-feed treatment plant according to Claims 1, 2 or 3, **characterized in that** the chassis (12) of the winding stations forms a chamber enclosed by the common stand (11) and a bearing plate (15) and a further wall provided with an opening to a shutoff valve (18), and side walls.

5. Through-feed treatment plant according to any one of the preceding claims, **characterized in that** its housing (1) has at least one winding-station loading/unloading opening (7) closable by means of a chamber cover (8).

6. Through-feed treatment plant according to Claims 4 and 5, **characterized in that** when the chassis (12) is located inside the housing (1), an opening (13) of the chamber of the chassis (12) faces the opening closed by the chamber cover (8) and is aligned therewith so as to allow changes of substrate carriers (17) after the chamber cover (8) has been opened.

7. Through-feed treatment plant according to Claim 6, **characterized in that** the opening (13) is surrounded by a seal (14) which in the operative condition of the plant is placeable between an inner wall (6) of the housing (1) and the rim of the opening (13), the said seal (14) being arranged on either the chassis (12) or the housing (1).

8. Through-feed treatment plant according to Claim 7, **characterized in that** the seal (14) is placeable against a flat inner wall (6) of the housing.

9. Through-feed treatment plant according to Claim 7 or 8, **characterized in that** the seal (14) is operable by fluid pressure, preferably into a sealed position (pressurized) and a retracted position (pressure-relieved, or subjected to reduced pressure).

10. Through-feed treatment plant according to Claim 7 or 8, **characterized in that** a connection for evacuating the plant terminates at the surface surrounded by the seal (14).

11. Through-feed treatment plant according to any one of the preceding claims, **characterized in that** at least one shutoff valve (18) is arranged in the chassis (12) of the winding stations (10).

12. Through-feed treatment plant according to Claim 11, **characterized in that** the shutoff valve (18) comprises a sealing face (5) which frames an opening (19) provided as a leadthrough for the substrate (17), and a body (21) for closing the opening (19) that can be pressed on to the sealing face and/or on to the substrate (17) extending through the opening (19) to close off the opening (19) by making at least indirect contact with the edges of the sealing face.

13. Through-feed treatment plant according to Claim 12, **characterized in that** the strip substrate is fixable in the opening (19) by means of the body (21), in particular to assist the drawing-in of a new substrate with the aid of a residual piece fixed in the shutoff valve (18).

14. Through-feed treatment plant according to any one of the preceding claims, **characterized in that** the valves (18) are arranged, individually or in combination, in a separate housing or chassis, and attached to the chassis (12).

## Revendications

1. Installation de traitement au passage pour le traitement, en particulier pour le revêtement, de substrats flexibles passants (17S) tels que des bandes, des films et analogues, comprenant une station de bobinage (10 ; 10') respectivement pour le débobinage et le bobinage du substrat flexible, au moins une station de traitement (B) disposée au niveau du passage du substrat entre ces deux stations, et des vannes (18), chacune disposée entre une station de bobinage (10 ; 10') et ladite au moins une station de traitement, pour l'obtention de différents niveaux de pression dans les stations de bobinage et dans ladite au moins une station de traitement, les stations de bobinage étant disposées sur une base (11) mobile et pouvant être sorties de l'installation, par exemple pour le changement du substrat, **caractérisée en ce que :**
- les stations de bobinage (10 ; 10') et la station de traitement (B) sont disposées dans ou sur des bases différentes, mobiles l'une par rapport à l'autre, la base de la station de traitement étant fixe et sous la forme d'une partie d'un carter (1) enveloppant la station de traitement (B) et, en fonctionnement, également la station de bobinage (10 ; 10') et contenant les vannes (18),
- les stations de bobinage (10 ; 10') sont disposées dans un bâti (12) comprenant leur base (11) et comportant des ouvertures obturables par les vannes (18), bâti qui est logé, en fonctionnement, à l'intérieur du carter (1) de la station de traitement, sachant que dans l'état ouvert des vannes (18), la station de traitement (B) et les stations de bobinage (10 ; 10') peuvent être mises sous vide ensemble, et que dans l'état fermé des vannes (18), la station de traitement (B) est fermée de façon étanche par rapport aux stations de bobinage (10 ; 10'), de telle sorte que les stations de bobinage peuvent être ouvertes à l'atmosphère indépendamment de la station de traitement.

2. Installation de traitement au passage selon la revendication 1, **caractérisée en ce que** la base (11) de la station de bobinage forme une paroi du bâti (12) et comprend au moins une embase (16) pour un porte-substrat (17).

3. Installation de traitement au passage selon la revendication 1 ou 2, **caractérisée en ce que,** pendant le fonctionnement de l'installation, la base (11) de la station de bobinage forme au moins une partie d'une paroi du carter (1).

4. Installation de traitement au passage selon la revendication 1, 2 ou 3, **caractérisée en ce que** le bâti (12) des stations de bobinage forme une chambre limitée par la base (11), commune, et limitée par une plaque porte-palier (15) ainsi que par une autre paroi dotée d'une ouverture orientée vers une vanne de sas (18), et par des parois latérales.

5. Installation de traitement au passage selon l'une quelconque des revendications précédentes, **caractérisée en ce que** son carter (1) comporte au moins une ouverture de chargement et/ou de déchargement (7) pour station de bobinage, ouverture pouvant être obturée au moyen d'un couvercle de chambre (8).

6. Installation de traitement au passage selon les revendications 4 et 5, **caractérisée en ce que,** lorsque le bâti (12) se trouve dans le carter (1), une ouverture (13) de la chambre du bâti (12) est tournée vers l'ouverture (7) fermée par le couvercle de chambre (8) et est alignée avec cette ouverture pour permettre un changement des porte-substrats (17) après l'ouverture du couvercle de chambre (8).

7. Installation de traitement au passage selon la revendication 6, **caractérisée en ce que** l'ouverture (13) est entourée par un joint d'étanchéité (14), lequel peut être appliqué pendant le fonctionnement de l'installation entre une paroi interne (6) du carter (1) et le bord de l'ouverture (13), ledit joint (14) étant disposé dans le bâti (12) ou dans le carter (1).

8. Installation de traitement au passage selon la revendication 7, **caractérisée en ce que** le joint (14) peut être appliqué contre une paroi interne (6) plane du carter.

9. Installation de traitement au passage selon la revendication 7 ou 8, **caractérisée en ce que** le joint (14) est commandable par la pression d'un fluide, de préférence dans une position d'étanchement (pressé) et dans une position de retrait (relâché ou mis sous vide).

10. Installation de traitement au passage selon la revendication 7 ou 8, **caractérisée en ce qu'**un raccord de mise sous vide de l'installation débouche dans la surface entourée par le joint (14).

11. Installation de traitement au passage selon l'une quelconque des revendications précédentes, **caractérisée en ce qu'**au moins une vanne de sas (18) est disposée dans le bâti (12) des stations de bobinage (10).

12. Installation de traitement au passage selon la revendication 11, **caractérisée en ce que** la vanne de sas (18) comprend une surface d'étanchéité (5) qui entoure à la manière d'un encadrement une ouverture (19) prévue pour le passage du substrat (17), et un corps (21) pour fermer l'ouverture (19) qui peut être appliqué sur la surface d'étanchéité et/ou sur le substrat (17) traversant l'ouverture (19) de telle sorte qu'il obture l'ouverture (19) en appuyant au moins indirectement sur les bords de la surface d'étanchéité.

13. Installation de traitement au passage selon la revendication 12, **caractérisée en ce que** le substrat en bande peut être fixé dans l'ouverture (19) au moyen du corps (21), en particulier pour assister la traction d'un nouveau substrat à l'aide d'un morceau restant fixé dans la vanne de sas (18).

14. Installation de traitement au passage selon l'une quelconque des revendications précédentes, **caractérisée en ce que** les vannes (18) sont disposées chacune individuellement ou en une pluralité dans un carter ou un bâti séparé et sont fixées dans le bâti (12).
